(19) **Europäisches Patentamt European Patent Office Office européen des brevets**

(11) **EP 4 650 810 A1**

(12) **EUROPEAN PATENT APPLICATION**

(43) Date of publication:
19.11.2025 Bulletin 2025/47

(21) Application number: 24175369.8

(22) Date of filing: 13.05.2024

(51) International Patent Classification (IPC):
*G01R 33/561* (2006.01)  *G01R 33/565* (2006.01)

(52) Cooperative Patent Classification (CPC):
G01R 33/56509; G01R 33/5611

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
GE KH MA MD TN

(71) Applicant: Koninklijke Philips N.V.
5656 AG Eindhoven (NL)

(72) Inventors:
• SOMMER, Karsten
  Eindhoven (NL)
• KEUPP, Jochen
  Eindhoven (NL)
• LEE, Yoo Jin
  5656AG Eindhoven (NL)

(74) Representative: Philips Intellectual Property &
Standards
High Tech Campus 52
5656 AG Eindhoven (NL)

(54) **MOTION-DEPENDENT REPETITION OF COIL SENSITIVITY MAP ACQUISITION**

(57) Disclosed herein is a method of operating a medical system (100), comprising: determining (200) initial position data (146) using a motion detection component, wherein the initial position data (146, 152) is descriptive of a subject within an imaging zone; acquiring (202) an initial coil sensitivity map (148) by controlling a magnetic resonance imaging system with coil sensitivity map pulse sequence commands; acquiring (204) imaging k-space data (150) according to a parallel imaging magnetic resonance imaging protocol by controlling the magnetic resonance imaging system with imaging pulse sequence commands; determining (206) subsequent position data (152) using the motion detection component; acquiring (208) at least one subsequent coil sensitivity map (154) by controlling the magnetic resonance imaging system with the coil sensitive map pulse sequence commands if the subsequent position data varies by more than a predetermined change since acquisition of a most recent coil sensitivity map; reconstructing (212) a magnetic resonance image (160, 402) based on the imaging k-space data and the at least one subsequent coil sensitivity map. A medical system is further presented, comprising a computational system configured to perform the method.

Fig. 1

EP 4 650 810 A1

Fig. 1

**Description**

TECHNICAL FIELD

The invention relates to magnetic resonance imaging, in particular to parallel imaging magnetic resonance imaging techniques.

BACKGROUND

A large static magnetic field is used by Magnetic Resonance Imaging (MRI) scanners to align the nuclear spins of atoms as part of the procedure for producing images within the body of a patient. This large static magnetic field is referred to as the B0 field or the main magnetic field. A common problem with magnetic resonance imaging is that the acquisition of k-space data for generating or with other words reconstructing a magnetic resonance image is time consuming.

One means of accelerating magnetic resonance imaging is by using parallel imaging techniques. In parallel imaging, multiple antenna elements, each with a local sensitivity, are used simultaneously. In one parallel imaging technique SENSE, a coil sensitivity map is used to combine the images from each of the multiple coil elements into a combined image. This, however, does not work with joint optimization reconstructions where the image is simultaneously reconstructed at the same time that motion parameters of the subject are determined. The coil sensitivity maps are also used in other types of parallel imaging techniques such as compressed sensing, based on unrolled artificial intelligence (AI) networks, and compressed sensing with AI regularization.

The journal article Cordero-Grande et. al., "Sensitivity Encoding for Aligned Multishot Magnetic Resonance Reconstruction," IEEE Trans. on Computational Imaging, Vol. 2, No. 3, Sept. 2016, pp. 266- 280 discloses a joint optimization reconstruction that incorporates coils sensitivity maps and is suitable for use in parallel imaging magnetic resonance imaging techniques.

SUMMARY

The invention provides a medical system, a method, and a computer program. The invention is presented in the independent claims, with further embodiments given in the dependent claims. Yet further embodiments are presented in the Summary section and the Detailed Description.

In one aspect, a medical system that comprises a magnetic resonance imaging system, which is configured for acquiring imaging k-space data from a subject at least partially within an imaging zone, is disclosed. The medical system further comprises a motion detection component configured for determining position data descriptive of the subject within the imaging zone. The medical system may further comprise a memory storing machine-executable instructions, coil sensitivity map pulse sequence commands, and imaging pulse sequence commands. The medical system further comprises a computational system that is configured for controlling the medical system. Execution of the machine-executable instructions causes the computational system to determine initial position data using the motion detection component. Execution of the machine-executable instructions further causes the computational system to acquire an initial coil sensitivity map by controlling the magnetic resonance imaging system with the coil sensitivity map pulse sequence commands.

Execution of the machine-executable instructions further causes the computational system to acquire imaging k-space data according to a parallel imaging magnetic resonance imaging protocol by controlling the magnetic resonance imaging system with the imaging pulse sequence commands. Execution of the machine-executable instructions further causes the computational system to determine subsequent position data using the motion detection component. Execution of the machine-executable instructions further causes the computational system to acquire at least one subsequent coil sensitivity map by controlling the magnetic resonance imaging system with the coil sensitivity map pulse sequence commands if the subsequent position data varies by more than a predetermined change since acquisition of a most recent coil sensitivity map. Execution of the machine-executable instructions further causes the computational system to form a collection of available coil sensitivity maps and position data from the initial coil sensitivity map and the at least one subsequent coil sensitivity map. Execution of the machine-executable instructions further causes the computational system to reconstruct a magnetic resonance image from the imaging k-space data using a joint optimization using the collection of available coil sensitivity maps.

In another aspect, a method of operating a medical system is disclosed. The medical system comprises a magnetic resonance imaging system configured for acquiring imaging k-space data from a subject at least partially within an imaging zone. The medical system further comprises a motion detection component configured for determining position data descriptive of the subject within the imaging zone. The medical system further comprises a memory storing machine-executable instructions, coil sensitivity map pulse sequence commands, and imaging pulse sequence commands.

The method comprises determining initial position data using the motion detection component. The method further comprises acquiring an initial coil sensitivity map by controlling the magnetic resonance imaging system with the coil sensitivity map pulse sequence commands. The method further comprises acquiring imaging k-space data according to a parallel imaging magnetic resonance imaging protocol by controlling the magnetic resonance imaging system with the imaging pulse sequence commands. The method further comprises determining subsequent position data using the motion detection component.

The method further comprises acquiring at least one subsequent coil sensitivity map by controlling the magnetic resonance imaging system with the coil sensitivity map pulse sequence commands if the subsequent position data varies by more than a predetermined change since acquisition of a most recent coil sensitivity map. The method further comprises forming a collection of available coil sensitivity maps and position data from the initial coil sensitivity map and the at least one subsequent coil sensitivity map. The method further comprises reconstructing a magnetic resonance image from the imaging k-space data using a joint optimization using the collection of available coil sensitivity maps.

In another aspect, a computer program comprising machine-executable instructions for execution by a computational system is disclosed. Execution of the machine-executable instructions causes the computational system to perform a method as described above or according to the claims.

BRIEF DESCRIPTION OF THE DRAWINGS

In the following preferred embodiments of the invention will be described, by way of example only, and with reference to the drawings in which:

Fig. 1 illustrates an example of a medical system.
Fig. 2 shows a flow chart which illustrates a method of using the medical system of Fig. 1.
Fig. 3 illustrates an example of motion data.
Fig. 4 illustrates the benefit of examples by showing two magnetic resonance images reconstructed from the same k-space data.

DETAILED DESCRIPTION

For the purposes of promoting and understanding the principles of the present disclosure, reference will now be made to the embodiments illustrated in the drawings, and specific language will be used to describe the same. It is nevertheless understood that no limitation to the scope of the disclosure is intended. Any alterations and further modifications to the described devices, systems, and methods, and any further application of the principles of the present disclosure are fully contemplated and included within the present disclosure as would normally occur to one skilled in the art to which the disclosure relates. In particular, it is fully contemplated that the features, components, and/or steps described with respect to one embodiment may be combined with the features, components, and/or steps described with respect to other embodiments of the present disclosure. For the sake of brevity, however, the numerous iterations of these combinations will not be described separately. Features described in relation to a system, may be implemented in a computer implemented method and/or in a computer program product, in a corresponding manner. Like numbered elements in these figures are either equivalent elements or perform the same function. Elements which have been discussed previously will not necessarily be discussed in later figures if the function is equivalent.

In one example a medical system comprises a magnetic resonance imaging system that is configured for acquiring imaging k-space data from a subject at least partially within an imaging zone. Magnetic resonance imaging systems comprise a magnet or so-called main magnet which generates a large static magnetic field which is often referred to as the B0 or main magnetic field. The imaging zone, as used herein, encompasses a region which has a magnetic field that is strong enough and uniform enough to perform magnetic resonance imaging. The medical system further comprises a motion detection component configured for determining position data descriptive of the subject within the imaging zone.

In various examples, the motion detection component can be implemented in different ways. The motion detection component may for example be a hardware component or a software component. In this sense the motion detection can measure the position data directly or it may determine the position data indirectly, for example through k-space navigator measurement or using the imaging k-space data to determine the position data. In some examples a camera system may be used to detect anatomical key points or reference points and used to accurately measure the position of the subject using two or three-dimensional cameras. In other examples, the motion detection component may be integrated into the magnetic resonance imaging system. As a further example, a software component may be implemented such that during the acquisition of the imaging k-space data the acquisition of navigator k-space data may be acquired in an interleaved fashion. This navigator data may for example be k-space measurements which are used to simply detect the motion of the subject in a particular direction or means. In yet another example of a software component, the joint optimization itself may be used to determine the position data. The joint optimization could be run on acquired k-space data or as the k-space data is being acquired.

The medical system may further comprises a memory storing machine-executable instructions, coil sensitivity map pulse sequence commands, and imaging pulse sequence commands. The machine-executable instructions may comprise instructions which enable a computational system to control and operate the medical imaging system. This may include such tasks as controlling various hardware components and also performing various imaging and numerical processes. The coil sensitivity map pulse sequence commands are used to take measurements from magnetic resonance imaging coils which are integrated into or are available to the magnetic resonance imaging system. For example, there may be a radio-frequency system which contains a multi-element antenna used to perform so-called parallel imaging magnetic resonance imaging techniques. The coil sensitivity map pulse sequence commands would acquire k-space data for each of these antenna elements and also possibly for a body coil. These measurements would then be used to generate individual coil images which are then combined to determine a coil sensitivity map for each of the individual antenna elements. Parallel imaging techniques in magnetic resonance imaging as used herein encompass SENSE (SENSitivity Encoding) and ASSET (Array coil Spatial Sensitivity Encoding) magnetic resonance imaging techniques as well as various compressed sensing (CS) magnetic resonance imaging techniques. Parallel imaging techniques are standard in many clinical situations and the knowledge of how to acquire a coil sensitivity map is also routinely performed in the clinical setting.

In most MRI examinations, coil sensitivity maps (CSMs) that are required for the reconstruction of rapid image acquisition techniques like SENSE or CS are obtained via a single SENSE reference scan (SenseRefScan) that is performed at the beginning of the session. A problem arises if heavy motion occurs during one of the following clinical scans: in this case, reliable information on coil sensitivity in certain image regions may be missing, leading to impaired image quality. Importantly, if the patient permanently shifts to a new position, image quality of all following scans may be impaired, even if no further motion happens. Insertion of an additional SenseRefScan can in principle solve this problem, but it is difficult for the operator to judge whether this is necessary or not. On the other hand, given the additional scan time, insertion of a new SenseRefScan should be avoided if possible.

The imaging pulse sequence commands are used to control the magnetic resonance imaging system to acquire the imaging k-space data. Imaging k-space data refers to k-space data which is acquired for the purpose of generating or reconstructing a magnetic resonance image. The word 'imaging' in this case is a label used to indicate particular k-space data and to differentiate it from any measurements made during the measurement of the coil sensitivity maps.

The medical system further comprises a computational system configured for controlling the medical system. This may for example include controlling the operation and function of the magnetic resonance imaging system. Execution of the machine-executable instructions causes the computational system to determine initial position data using the motion detection component. The initial position data provides position data that is descriptive of the position of the subject before the beginning of the acquisition of imaging k-space data. Execution of the machine-executable instructions further causes the computational system to acquire an initial coil sensitivity map by controlling the magnetic resonance imaging system with the coil sensitivity map pulse sequence commands. This may for example include such steps as acquiring coil sensitivity map k-space data, reconstructing individual images for various coil elements and then calculating or determining the coil sensitivity map.

Execution of the machine-executable instructions further causes the computational system to acquire imaging k-space data according to a parallel imaging magnetic resonance imaging protocol by controlling the magnetic resonance imaging system with the imaging pulse sequence commands. The imaging pulse sequence commands are configured such that they use a parallel imaging technique. Execution of the machine-executable instructions further causes the computational system to determine subsequent position data using the motion detection component. This step may take different forms in different examples. In some examples the subsequent position data is only determined at the end of the procedure. In other examples, the subsequent position data may be acquired repeatedly throughout the acquisition of the imaging k-space data. For example, if the subsequent position data is acquired using a camera system, this can easily be performed on a continuous or repeated basis. In the case where the motion detection component is implemented using the magnetic resonance imaging system and uses so-called navigators, then the subsequent position data could be determined periodically during the acquisition of the imaging k-space data by interleaving pulse sequence commands to acquire the navigator k-space data. In some examples the subsequent position data is derived or determined from the imaging k-space data as it is acquired. Execution of the machine-executable instructions further causes the computational system to acquire at least one subsequent coil sensitivity map by controlling the magnetic resonance imaging system with the coil sensitivity map pulse sequence commands if the subsequent position data varies by more than a predetermined change since acquisition of a most recent coil sensitivity map. The most recent coil sensitivity map may be interpreted as the most recently acquired coil sensitivity map. For example, the most recent coil sensitivity map may be the official coil sensitivity map. If a subsequent coil sensitivity map is acquired during the acquisition of the imaging k-space data, then the most recent coil sensitivity map may be the most recently acquired subsequent coil sensitivity map.

Execution of the machine-executable instructions further causes the computational system to form a collection of available coil sensitivity maps and position data from the initial coil sensitivity map and the at least one subsequent coil sensitivity map. The collection of available coil sensitivity maps is essentially a set of coil sensitivity maps for the subject that may be used during image reconstruction. Execution of the machine-executable instructions further causes the computational system to reconstruct a magnetic resonance image from the imaging k-space data using a joint optimization using the collection of available coil sensitivity maps. A joint optimization is an image reconstruction technique that simultaneously reconstructs the magnetic resonance image and determines motion parameters using an optimization.

By using the collection of available coil sensitivity maps the particular coil sensitivity map, which best matches the motion state of the subject, can be used during the reconstruction. This may for example cause a reduction in the number of image artifacts and may result in an improved image quality in the magnetic resonance image. Several different example techniques for reconstructing the magnetic resonance image using the collection of available coil sensitivity maps are described below.

An example of a typical joint optimization reconstruction algorithm is shown in Eq. 1:

$$\hat{x} = \underset{x,\theta}{argmin} \|AFCT(\theta)x - y\|_2^2 \qquad \text{Eq. 1}$$

In this equation, where $x$ is the image to be estimated, $y$ is the acquired k-space data (imaging k-space data), $\theta$ is a set of motion parameters, $T$ is the motion transform matrix ($T$ is a function of $\theta$), $C$ is a matrix containing the coil sensitivities (coil sensitivity map), $F$ is the Fourier transform and $A$ is the sampling matrix. In detail, the matrix $C$ has the form:

$$C = \begin{bmatrix} C_1 & \cdots & 0 \\ \vdots & \ddots & \vdots \\ C_{n_c} & \cdots & 0 \\ \vdots & \ddots & \vdots \\ 0 & \cdots & C_{n_c} \end{bmatrix} \qquad \text{Eq. 2}$$

where $C_j$ is a diagonal matrix whose diagonal elements are given by the coil sensitivity profile of coil $j$. This method of reconstructing a magnetic resonance image is referred to as a joint reconstruction because the motion transform matrix is determined (and adjusted using the variable $\theta$) at the same time as the image $x$ is reconstructed. The k-space data is divided into groups or portions and are processed separately within the optimization problem. In equation 1 and 2, the submatrices $C_j$ within $C$ are all identical and given by the single coil sensitivity map that is used for the reconstruction. Examples improve upon this to provide a higher quality reconstruction.

Eq. 3 below illustrates an improvement to the joint estimation:

$$\hat{x} = \underset{x,\theta}{argmin} \|AFC_i AF\tilde{C}(k)T(\theta)x - y\|_2^2 \qquad \text{Eq. 3}$$

with the new matrix $\tilde{C}$ is given by

$$\tilde{C}(k) = \begin{bmatrix} C_{11}(k_1) & \cdots & 0 \\ \vdots & \ddots & \vdots \\ C_{1n_c}(k_1) & \cdots & 0 \\ \vdots & \ddots & \vdots \\ 0 & \cdots & C_{n_s n_c}(k_{n_s}) \end{bmatrix} \qquad \text{Eq. 4}$$

where the submatrices $C_{ij}$ are diagonal matrices whose diagonal elements are given by the coil sensitivity profile of coil $j$ assigned to the motion state $i$. In other words, for each motion state a different coil sensitivity map can be selected from the collection of all available coil sensitivity maps via the parameter $k_i \in \{1 \dots N_c\}$, where $N_c$ is the number of available coil sensitivity maps. For example, the reconstruction algorithm could assign the proper coil sensitivity parameter to choose the coil sensitivity map that correlates, according to a time stamp, to a particular group or portion of the imaging k-space data. The position data stored in the collection of coil sensitivity maps may be compared to the motion data $\theta$ to find the most suitable $k_i$ from the collection of coils sensitivity maps.

Examining Eq. 3, also illustrates one way of obtaining the motion data. The variable $\theta$ could itself be the motion data. Retrospectively, k-space data can be acquired and the solution of Eq. 3 can be used to determine $\theta$ as the motion data. This technique can also be used on the fly as k-space data is being acquired. The k-space data which has been acquired up to a certain point in time can be put into Eq. 3 and although there may not be enough k-space data to reconstruct a full image, it may allow the determination of $\theta$, which can be used as the motion data. These statements also apply to Eq.5 below.

Eq.5 illustrates a further modification to the joint estimation over Eq. 3 and Eq. 4:

$$\hat{x} = \underset{x,\,\theta,k}{argmin}\left\|AF\tilde{C}(k)T(\theta)x - y\right\|_2^2 \qquad \text{Eq. 5}$$

In Eq. 5, the selection of the coil sensitivity parameter vector k is part of the optimization problem and thus the coil sensitivity map is changed automatically during the solution of the joint estimation for portions of the k-space data. This may lead to increased computational cost, but it may have several advantages. Firstly, the solution of the joint optimization is no longer sensitive to time stamps correlating portions of the imaging k-space data with a particular coil sensitivity map as portions using the same $C_i$ may be distributed over the entire range of k-space data. Correlation between position data in the collection of sensitivity maps and the estimated $\theta$ may aid the optimization of k.

A joint optimization according to Eq. 5 may also enable the use of coil sensitivity maps acquired from the same subject during prior scans. For example, the subject may be positioned in the magnetic resonance imaging system and then have several different imaging protocols performed without the subject being removed from the magnetic resonance imaging system. It is possible that prior coil sensitivity maps may result in an improvement in image quality, for example, when the patient moves back to a position recorded in this prior sensitivity map. These prior coil sensitivity maps can simply be appended to the collection of coil sensitivity maps. If these prior coil sensitivity maps are invalid or do not work because the subject has moved the joint optimization in Eq. 5 will automatically reject them.

Another potential advantage is that coil sensitivity maps can be synthetically generated from existing coils sensitivity maps and tried using Eq. 5. For example, two coil sensitivity maps could be averaged to produce a third coil sensitivity map:

$$C_c = (C_a + C_b)/2 \qquad \text{Eq. 6}$$

In Eq. 6, $C_c$ is an element-wise average of $C_a$ and $C_b$. The resulting $C_c$ may be an intermediate of the two existing coil sensitivity maps $C_a$ and $C_b$. The validity and usefulness of $C_c$ is tested automatically by the optimization in Eq. 5. If $C_c$ is not beneficial in a particular reconstruction, it is rejected by the optimization. Also, position data averaged between the position data of $C_a$ and $C_b$, can be stored together with the synthetic coil sensitivity map $C_c$.

A modification to Eq. 6 is:

$$C_c = \alpha C_a + \beta C_b \qquad \text{Eq. 7}$$

with $\alpha + \beta = 1$. In Eq. 7, $C_c$ is a linear combination of $C_a$ and $C_b$. Eq.7 could be used to generate multiple coils sensitivity maps. For example, the subject could start in one position and then gradually move or change positions during the course of the magnetic resonance imaging examination. It could be impractical to measure many different coil sensitivity maps. In this example, two coil sensitivity maps, one at the beginning of the examination (the initial coil sensitivity map) and one at the end (the final coil sensitivity map) could be used to generate multiple intermediate coil sensitivity maps. The optimization problem in Eq. 5 would correctly assign (or ignore) these intermediate coil sensitivity maps.

In another example, the collection of available coil sensitivity maps is referenced to respective position data determined with the motion detection component. This could, for example, mean that position data is acquired at the same time as a coil sensitivity map as stored with or used to index, reference, or find the coil sensitivity map. This may, for example, be used to choose the coil sensitivity map for a particular $C_i$ in Eq. 2 or may be suited to choose an initial $C_i$ in Eq. 2.

In another example, the at least one subsequent coil sensitivity map comprises a final coil sensitivity map acquired after acquisition of the imaging k-space data is finished. The acquisition of subsequent coil sensitivity maps may extend the time needed to complete the data acquisition for this image. Acquiring only a single coil sensitivity map after the completion of the acquisition of the imaging k-space data may be beneficial because the acquisition of intermediate coils sensitivity maps does not interrupt the acquisition of the imaging k-space data. It may for example have the benefit of reducing the amount of time necessary for the acquisition of the imaging k-space data as well as reducing the chances that the subject moves during acquisition of the imaging k-space data.

In another example, execution of the machine-executable instructions further causes the computational system to repeatedly acquire the subsequent position data during the acquisition of the k-space data. In this example, the subsequent position data is repeatedly acquired during the magnetic resonance imaging protocol. This may have the benefit that there may be more data, which is more descriptive of the position of the subject during the acquisition of the imaging k-space data. This may for example enable better determination of when to acquire the subsequent coil sensitivity map as well as choosing which coil sensitivity map to use during the reconstruction of the magnetic resonance image. The choice of the sensitivity maps may be guided by comparing the repeatedly acquired or determined position data with the position data stored with the collection of sensitivity maps.

In another example, execution of the machine-executable instructions further causes the computational system to reuse the collection of available coil sensitivity maps during the reconstruction of a subsequent magnetic resonance image from subsequently acquired k-space data. For example, during an imaging protocol or procedure for a subject, multiple batches of k-space data may be acquired for acquiring different types of magnetic resonance images. The collection of available coil sensitivity maps may for example in this case be reused in a joint optimization and the subsequent magnetic resonance image is reconstructed from the subsequently acquired k-space data. In some examples it may be difficult to choose the correct coil sensitivity map from the collection of available coil sensitivity maps on a completely different reconstruction.

However, in the joint optimization, the selection of the particular coil sensitivity map can be made as one of the optimization parameters. In this case, one does not need to have a timestamp or correlation between the acquired k-space data and the particular coil sensitivity map. It may for example improve the image quality of the subsequent magnetic resonance image because a larger variety of coil sensitivity maps are available and may be automatically or optimally selected using the joint optimization.

In another example, execution of the machine-executable instructions further causes the computational system to pause the acquisition of the imaging k-space data to acquire the at least one subsequent coil sensitivity map. In this example, instead of having just a coil sensitivity map for example beginning and end, the imaging k-space data is paused to allow for additional coil sensitivity maps to be acquired. This may for example be very useful in long magnetic resonance imaging procedures where a large amount of time would be lost if the imaging procedure needs to be restarted. This may also be particularly beneficial in imaging small children or other people who have a difficult time remaining still during a magnetic resonance imaging session. In this case, multiple coil sensitivity maps could be acquired and used in the joint reconstruction to reconstruct a better image that has fewer motion artifacts due to the use of an incorrect or suboptimal coil sensitivity map.

In another example, execution of the machine-executable instructions further causes the computational system to generate additional coil sensitivity maps by numerically combining the initial coil sensitivity map and the at least one subsequent coil sensitivity map. This is illustrated in Eq. 6 and Eq. 7 above. Execution of the machine-executable instructions further causes the computational system to append the additional coil sensitivity maps to the collection of available coil sensitivity maps. In this example, two coil sensitivity maps are used to combine and construct one or more additional coil sensitivity maps. For example, two existing coil sensitivity maps could be averaged or a linear combination of the two could be used. Position data may also be estimated for the numerically combined coil sensitivity maps based on the position data in the collection. This, for example, may be useful in situations where a subject moves gradually or over time. Any one particular coil sensitivity map may not be perfectly correct or the best coil sensitivity map to use. This may provide for an effective means of generating additional coil sensitivity maps to improve image quality without delaying the acquisition of the imaging k-space data.

In another example, the coil sensitivity maps are generated numerically by combining the initial coil sensitivity map and the at least one subsequent coil sensitivity map using any one of the following: the first is by averaging any two coil sensitivity maps (cf. Eq. 6 above) chosen from the initial coil sensitivity map and the at least one subsequent coil sensitivity map and the second is by linearly combining (cf. Eq. 7 above) any two coil sensitivity maps chosen from the initial coil sensitivity map and the at least one coil sensitivity map using varying scalar coefficients. For example, the coil sensitivity maps may include maps for the individual coil elements used to acquire the imaging k-space data in the parallel imaging technique. One may for example, just take the coil sensitivity map for a particular element and then average them to obtain a third coil sensitivity map. This may for example in many circumstances represent an intermediate coil sensitivity map. Likewise, multiple coil sensitivity maps can be generated by taking two existing coil sensitivity maps and then making a linear combination of the two.

In another example, execution of the machine-executable instructions further causes the computational system to perform the joint optimization such that a coil sensitivity parameter is varied for different parts of the k-space data. The coil sensitivity parameter specifies one of the collection of available coil sensitivity maps. An example of a coil sensitivity parameter would be the variable k in Eqs. 3-5 above. In some instances, it may not be known which part of the k-space data should be used to pair with a particular coil sensitivity map. In this example, the optimization varies the coil sensitivity parameter and automatically selects the best coil sensitivity map to use for a particular part of the k-space data. This may also be particularly useful when you have additional coil sensitivity maps generated from already existing coil sensitivity maps that were measured. It may for example enable one to select coil sensitivity maps generated using averaging or linear combinations and use them as intermediate coil sensitivity maps and automatically select the best one to use.

In another example, execution of the machine executable instructions may further cause the computational system to solve the joint optimization such that coil sensitivity maps are selected, at least initially, from the collection of coil sensitivity maps using the respective position data. This example may be beneficial because the coil sensitivity maps used to solve Eq. 3 are at least initially selected using the position data determined using the motion detection component.

In another example, the at least one subsequent coil sensitivity map and the imaging k-space data are acquired using timestamps. Execution of the machine-executable instructions further causes the computational system to perform a selection of the at least one coil sensitivity map of the collection of available coil sensitivity maps for different portions of the joint optimization, at least initially using the timestamps. The timestamps could for example be used to select which coil sensitivity map is used for which portion of the joint optimization as well as using it to set up a set of initial conditions for an optimization where the coil sensitivity parameter is varied by the optimization automatically.

In these examples, the "different portions" of k-space data in the joint optimization may correspond to or be identical with the "different parts" of the k-space data. It is therefore possible to replace "different portions" with "different parts."

In another example, the motion detection component is at least partially implemented using a camera system. For example, two- or three-dimensional cameras may be used to image the subject when the subject is in the bore of the magnet. This may be very useful because it may be able to detect motion of the subject, which would be missed using a navigator.

In another example, the motion detection component is at least partially implemented using magnetic resonance imaging navigators. The navigators may also be useful in situations where the internal anatomy of the subject varies or is modified during the acquisition of the k-space data. Navigators may comprise k-space navigators, using one or a few k-space profiles, or image navigators using a range of k-space profiles to acquire a fast image update typically at low resolution. Navigators may also be useful in situations where a camera system is not available.

In another example, the execution of the machine executable instructions further causes the computational system to determine the position data from the imaging k-space data. In this example, the motion detection component is at least partially implemented as software. The imaging k-space data may be used to determine the position data, for example, by solving for $\theta$ in Eq. 2 or Eq. 3.

In another example, the motion detection component is at least partially implemented motion detection based on the imaging k-space data itself. This may be useful in situations where a change of the timing by adding navigators may prolong the data acquisition or may alter the image contrast. Detecting motion based on the imaging k-space data may also be useful in situations where a camera system or other external motion sensors are not available.

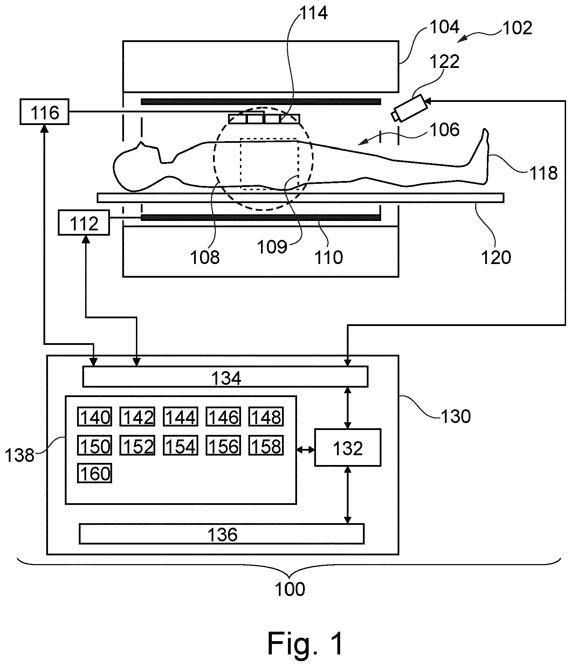

Fig. 1 illustrates an example of a medical system 100. The medical system 100 comprises a magnetic resonance imaging system 102 and a computer 130. The magnetic resonance imaging system 102 comprises a magnet 104. The magnet 104 is a superconducting cylindrical type magnet with a bore 106 through it. It is also possible to use both a split cylindrical magnet and a so-called open magnet. A split cylindrical magnet is similar to a standard cylindrical magnet, except that the cryostat has been split into two sections to allow access to the iso-plane of the magnet, such magnets may for instance be used in conjunction with charged particle beam therapy. An open magnet has two magnet sections, one above the other with a space in-between that is large enough to receive a subject. The arrangement of the two sections area is similar to that of a Helmholtz coil. Open magnets are popular because the subject is less confined. Inside the cryostat of the cylindrical magnet there is a collection of superconducting coils.

Within the bore 106 of the cylindrical magnet 104 there is an imaging zone 108 where the magnetic field is strong and uniform enough to perform magnetic resonance imaging. A field of view 109 is shown within the imaging zone 108. The k-space data are acquired for the field of view 109. The region of interest could be identical with the field of view 109 or it could be a sub volume of the field of view 109. A subject 118 is shown as being supported by a subject support 120 such that at least a portion of the subject 118 is within the imaging zone 108 and the field of view 109.

Within the bore 106 of the magnet there is also a set of magnetic field gradient coils 110 which is used for the acquisition of measured k-space data to spatially encode magnetic spins within the imaging zone 108 of the magnet 104. The magnetic field gradient coils 110 are connected to a magnetic field gradient coil power supply 112. The magnetic field gradient coils 110 are intended to be representative. Typically, magnetic field gradient coils 110 contain three separate sets of coils for spatial encoding in three orthogonal spatial directions. A magnetic field gradient power supply supplies current to the magnetic field gradient coils. The current supplied to the magnetic field gradient coils 110 is controlled as a function of time and may be ramped or pulsed.

Adjacent to the imaging zone 108 is a radio frequency coil 114 for manipulating the orientations of magnetic spins within the imaging zone 108 and for receiving radio transmissions from spins also within the imaging zone 108. The radio frequency antenna may comprises multiple coil elements. The radio frequency antenna may also be referred to as a channel or antenna. The radio frequency coil 114 is connected to a radio frequency transceiver 116. The radio frequency coil 114 and radio frequency transceiver 116 may be replaced by separate transmit and receive coils and a separate transmitter and receiver. It is understood that the radio frequency coil 114 and the radio frequency transceiver 116 are representative. The radio frequency coil 114 is intended to also represent a dedicated transmit antenna and a dedicated receive antenna. Likewise, the transceiver 116 may also represent a separate transmitter and receiver. The radio frequency coil 114 has multiple receive/transmit elements and the radio frequency transceiver 116 has multiple receive/transmit channels. The transceiver 116 and the gradient controller 112 are shown as being connected to the hardware interface 106 of the computer system 102.

The medical system 100 is further shown as comprising a camera system 122 which is an example of a motion detection component. Alternative or additional motion detection components may be wearable motion detection sensors, for example based on optical techniques. The motion detection component, e.g., camera system 122 may for example be used for providing position data descriptive of the subject 118. In some examples the camera system 122 may provide anatomical key points so that very precise movement of the subject 118 may be tracked. The camera may be mounted inside the bore or outside of the bore 106. Other alternative or additional examples of motion detection component may for example be a hardware component or a software component. In this sense the motion detection can measure the position data directly or it may determine the position data indirectly, for example through k-space navigator measurement or using the imaging k-space data to determine the position data.

The transceiver 116, the magnetic field gradient coil power supply 112 and the camera system 122 are shown as being connected to a hardware interface of computer 130. The computer 130 is further shown as comprising a computational system 132. The computer 130 and the computational system 132 may be one or more computer systems or computational systems located at one or more locations. The hardware interface 134 may enable the computational system 132 to communicate with and to control other components of the medical system 100. The computational system 132 is further shown as being in communication with an optional user interface 136 and a memory 138. The memory 138 is intended to represent different types of memory which may be accessible to the computational system 132. The memory is intended to represent any combination of memory or storage device which is accessible to a computational system configured to control the MR acquisition and/or reconstruction. The memory may include volatile and non-volatile memory storage means and components. The memory in some embodiments may be based on or may rely on cloud-based data stored in logical pools across disparate, commodity storage servers located on premises or in a data center managed by a third-party cloud provider.

The memory 138 is shown as containing machine-executable instructions 140. The machine-executable instructions 140 enable the computational system 132 to perform various data and image processing tasks as well as to control the magnetic resonance imaging system 102. The memory 138 is further shown as comprising coil sensitivity map pulse sequence commands 142 that may be used for generating coil sensitivity maps. The memory 138 is further shown as containing imaging pulse sequence commands 144 that are configured to acquire imaging k-space data 150 according to a parallel imaging magnetic resonance imaging protocol. The memory 138 is further shown as containing initial position data 146 that was acquired with a motion detection component, for example with the camera system 122. The memory 138 is further shown as containing an initial coil sensitivity map 148 that was acquired before the start of the imaging k-space data 150. The memory 138 is further shown as containing the imaging k-space data 150 that was acquired by controlling the magnetic resonance imaging system 102 with the imaging pulse sequence commands 144.

The memory 138 is further shown as containing subsequent position data 152 that may for example have been acquired during the acquisition of the imaging k-space data 150 and/or after acquisition of the imaging k-space data 150 is finished. The memory 138 is further shown as containing at least one subsequent coil sensitivity map 154 that was acquired by controlling the magnetic resonance imaging system 102 with the coil sensitivity map pulse sequence commands 142 either when a pause was made in acquisition of the imaging k-space data 150 and/or after acquisition of the imaging k-space data 150 is finished. The memory 138 is further shown as containing a predetermined change 156, which may for example be absolute values or inequalities which are used to detect when there is a large change in the subsequent position data 152 relative to the initial position data 146 and/or large changes in continuously or repeatedly determined or acquired subsequent position data 152. The predetermined change 156 is used as a condition to trigger when the at least one subsequent coil sensitivity map 154 is acquired.

The memory 138 is further shown as containing a collection of available coil sensitivity maps 158 that were constructed by using the initial coil sensitivity map 148 and the at least one subsequent coil sensitivity map 154. The collection of available coil sensitivity maps 158 may also comprise position data for each contained coil sensitivity map. The collection of available coil sensitivity maps 158 may further comprise additional coil sensitivity maps made by averaging or combining the initial coil sensitivity map 148 and/or the at least one subsequent coil sensitivity map 154. The memory 138 is further shown as containing a magnetic resonance image 160 that was reconstructed from the imaging k-space data 150 using the collection of available coil sensitivity maps 158.

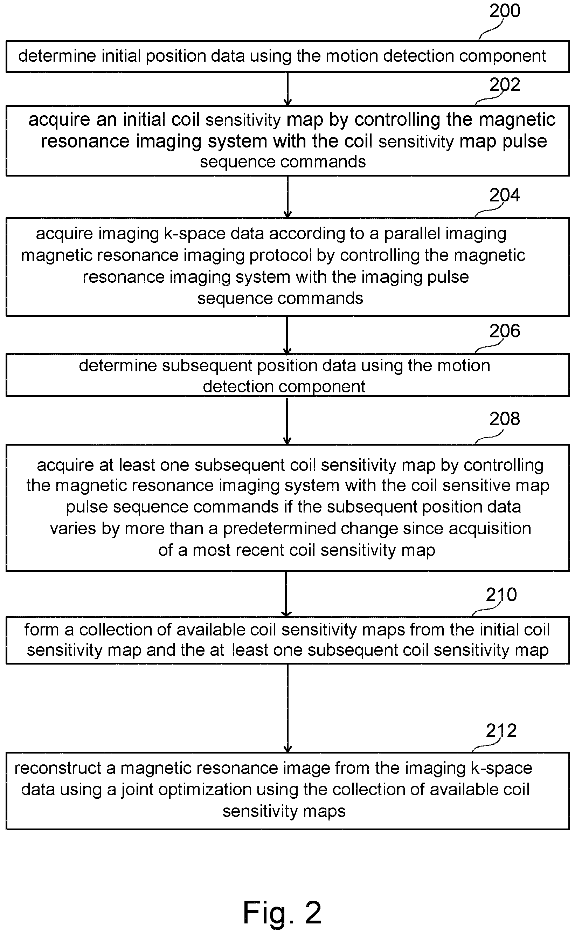

Fig. 2 shows a flowchart which illustrates a method of operating the medical system 100 of Fig. 1. In step 200, initial position data 146 is acquired by controlling the motion detection component or camera system 122 in this case. In step 202, the initial coil sensitivity map 148 is acquired by controlling the magnetic resonance imaging system 102 with the coil sensitivity map pulse sequence commands 142. In step 204, the imaging k-space data 150 is acquired by controlling the magnetic resonance imaging system 102 with the imaging pulse sequence commands 144. In step 206, subsequent position data 152 is acquired using the motion detection component 122. In step 208, the at least one subsequent coil sensitivity map 154 is acquired by controlling the magnetic resonance imaging system 102 with the coil sensitivity map pulse sequence commands 142 if the subsequent position data 152 varies by more than a predetermined change since acquisition of a most recent coil sensitivity map. In step 210 the collection of available coil sensitivity maps 158 is formed from the initial coil sensitivity map 148 and the at least one subsequent coil sensitivity map 154. In step 212, the magnetic resonance image 160 is reconstructed from the imaging k-space data 150 using a joint optimization that uses the collection of available coil sensitivity maps 158.

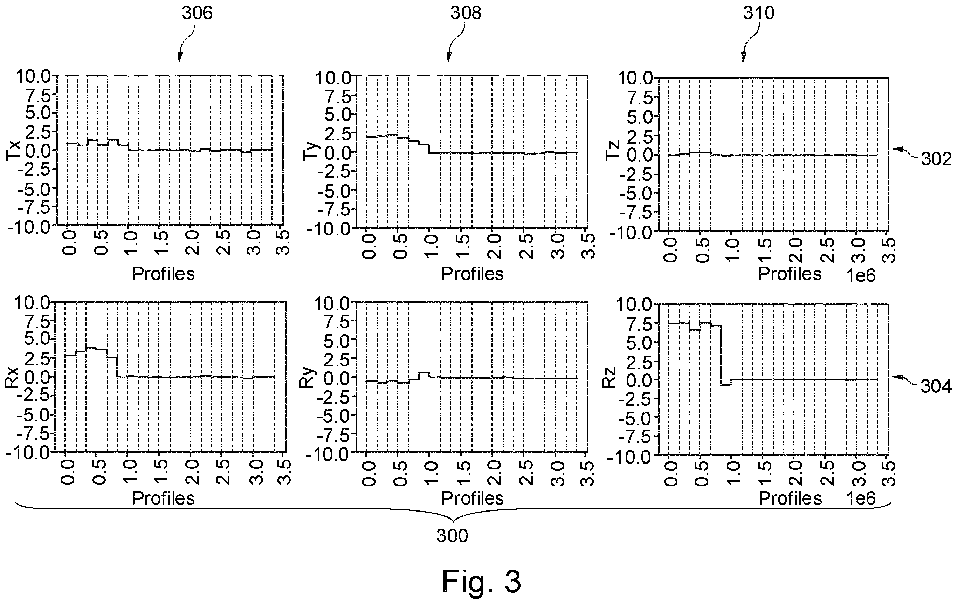

Fig. 3 illustrates an example of position data 300. There are six charts shown. In row 302, translational position data 302 is shown. In row 304, rotational position data is shown. This is shown for the *x*-axis 306, the *y*-axis 308, and the *z*-axis 310. The position data 300 is divided in this example into twenty (20) motion segments across the entire scan time during the acquisition of the imaging k-space data 150.

In particular, Fig. 3 shows the determined 3D motion parameters of a heavily motion-corrupted head scan. Two main motion states can be observed, with a major motion event at about when 25% of scan time elapsed. Since this was the first anatomical scan (acquisition of the imaging k-space data) after the initial coil sensitivity map, it could be expected that image quality of the following anatomical scans would be impaired, even if no further motion happens: the subject shifted to a new head position after the main motion event, so that a significant part of the required local coil sensitivity information is not available. The reason is that coil sensitivity can only be measured during a coil sensitivity scan in signal bearing areas inside the body. If parts of the body shift to a location that previously was not inside (air or other MR signal voids), sensitivity information must be newly obtained.

Examples may compare the 3D motion parameters (position data) of the first and last motion state to identify substantial bulk motion relative to the coil sensitivity map. Various metrics can be used for this comparison, such as the L1, L2, or maximum norm. Separate thresholds for translation and rotation are used.

In another implementation, the 3D motion described by the last motion state is applied to the coil sensitivity map data (e.g., the QBC data) and compared to the original motion free data. Substantial deviations at the edges of the volume are analyzed using a simple masking algorithm: tissue masks for the two datasets are determined by thresholding, and spatial overlap of the resulting masks is analyzed. If substantial bulk motion is detected, a subsequent coil sensitivity map is inserted into the exam automatically.

In an exemplary method embodiment of the invention an additional SENSE reference scan is automatically inserted into the MRI examination when it is necessary, based on analysis of motion corrected reconstruction results. The proposed algorithm compares the 3D motion parameters of subsequent motion states for identifying substantial bulk motion relative to the SENSE reference scan based on predetermined threshold, which may be related to translation and/or rotation. When multiple SENSE reference scans are available, the motion-compensated reconstruction can use all obtained coil sensitivity information to optimize results, e.g., for each motion segment, such as conform Fig. 3, coil sensitivity map closest to each specific segment's motion state is used by selecting the most suitable coil sensitivity map based on the lowest residual.

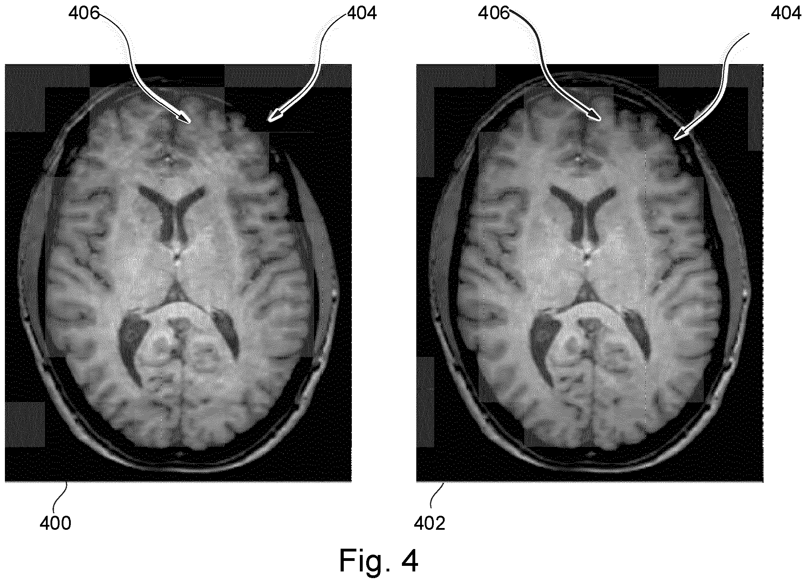

The potential impact of examples is illustrated in Fig. 4. Fig. 4 shows two different motion-compensated reconstructions of an anatomical 3D T1 weighted scan. Magnetic resonance image 400 was reconstructed only using the initial coil sensitivity map 148. Magnetic resonance image 402 was reconstructed using the same imaging k-space data 150 but it had an additional subsequent coil sensitivity map 154 that was acquired after scan completion. The arrows 404 note a region where the magnetic resonance image 402 has a more defined reconstruction of the skull. The subsequent coil sensitivity map avoids missing coil sensitivity values near the edges. Arrow 406 indicates a region where there are more motion image artifacts in magnetic resonance image 400. These two magnetic resonance images 400, 402 illustrate the benefit of using multiple coil sensitivity maps.

It is understood that one or more of the aforementioned examples or embodiments of the invention may be combined as long as the combined embodiments are not mutually exclusive.

As will be appreciated by one skilled in the art, aspects of the present invention may be embodied as an apparatus, method or computer program product. Accordingly, aspects of the present invention may take the form of an entirely hardware embodiment, an entirely software embodiment (including firmware, resident software, micro-code, etc.) or an embodiment combining software and hardware aspects that may all generally be referred to herein as a "circuit," "module" or "system." Furthermore, aspects of the present invention may take the form of a computer program product embodied in one or more computer readable medium(s) having computer executable code embodied thereon.

Any combination of one or more computer readable medium(s) may be utilized. The computer readable medium may be a computer readable signal medium or a computer readable storage medium. A 'computer-readable storage medium' as used herein encompasses any tangible storage medium which may store instructions which are executable by a processor or computational system of a computing device. The computer-readable storage medium may be referred to as a computer-readable non-transitory storage medium. The computer-readable storage medium may also be referred to as a tangible computer readable medium. In some embodiments, a computer-readable storage medium may also be able to store data which is able to be accessed by the computational system of the computing device. Examples of computer-readable storage media include, but are not limited to: a floppy disk, a magnetic hard disk drive, a solid state hard disk, flash memory, a USB thumb drive, Random Access Memory (RAM), Read Only Memory (ROM), an optical disk, a magneto-optical disk, and the register file of the computational system. Examples of optical disks include Compact Disks (CD) and Digital Versatile Disks (DVD), for example CD-ROM, CD-RW, CD-R, DVD-ROM, DVD-RW, or DVD-R disks. The term computer readable-storage medium also refers to various types of recording media capable of being accessed by the computer device via a network or communication link. For example, data may be retrieved over a modem, over the internet, or over a local area network. Computer executable code embodied on a computer readable medium may be transmitted using any appropriate medium, including but not limited to wireless, wire line, optical fiber cable, RF, etc., or any suitable combination of the foregoing.

A computer readable signal medium may include a propagated data signal with computer executable code embodied therein, for example, in baseband or as part of a carrier wave. Such a propagated signal may take any of a variety of forms, including, but not limited to, electro-magnetic, optical, or any suitable combination thereof. A computer readable signal medium may be any computer readable medium that is not a computer readable storage medium and that can communicate, propagate, or transport a program for use by or in connection with an instruction execution system, apparatus, or device.

'Computer memory' or 'memory' is an example of a computer-readable storage medium. Computer memory is any memory which is directly accessible to a computational system. 'Computer storage' or 'storage' is a further example of a computer-readable storage medium. Computer storage is any non-volatile computer-readable storage medium. In some embodiments computer storage may also be computer memory or vice versa.

A 'computational system' as used herein encompasses an electronic component which is able to execute a program or machine executable instruction or computer executable code. References to the computational system comprising the example of "a computational system" should be interpreted as possibly containing more than one computational system or processing core. The computational system may for instance be a multi-core processor. A computational system may also refer to a collection of computational systems within a single computer system or distributed amongst multiple computer systems. The term computational system should also be interpreted to possibly refer to a collection or network of computing devices each comprising a processor or computational systems. The machine executable code or instructions may be executed by multiple computational systems or processors that may be within the same computing device or which may even be distributed across multiple computing devices.

Machine executable instructions or computer executable code may comprise instructions or a program which causes a processor or other computational system to perform an aspect of the present invention. Computer executable code for carrying out operations for aspects of the present invention may be written in any combination of one or more programming languages, including an object-oriented programming language such as Java, Smalltalk, C++ or the like and conventional procedural programming languages, such as the "C" programming language or similar programming languages and compiled into machine executable instructions. In some instances, the computer executable code may be in the form of a high-level language or in a pre-compiled form and be used in conjunction with an interpreter which generates the machine executable instructions on the fly. In other instances, the machine executable instructions or computer executable code may be in the form of programming for programmable logic gate arrays.

The computer executable code may execute entirely on the user's computer, partly on the user's computer, as a stand-alone software package, partly on the user's computer and partly on a remote computer or entirely on the remote computer or server. In the latter scenario, the remote computer may be connected to the user's computer through any type of network, including a local area network (LAN) or a wide area network (WAN), or the connection may be made to an external computer (for example, through the Internet using an Internet Service Provider).

Aspects of the present invention are described with reference to flowchart illustrations and/or block diagrams of methods, apparatus (systems) and computer program products according to embodiments of the invention. It is understood that each block or a portion of the blocks of the flowchart, illustrations, and/or block diagrams, can be implemented by computer program instructions in form of computer executable code when applicable. It is further under stood that, when not mutually exclusive, combinations of blocks in different flowcharts, illustrations, and/or block diagrams may be combined. These computer program instructions may be provided to a computational system of a general-purpose computer, special purpose computer, or other programmable data processing apparatus to produce a machine, such that the instructions, which execute via the computational system of the computer or other programmable data processing apparatus, create means for implementing the functions/acts specified in the flowchart and/or block diagram block or blocks.

These machine executable instructions or computer program instructions may also be stored in a computer readable medium that can direct a computer, other programmable data processing apparatus, or other devices to function in a particular manner, such that the instructions stored in the computer readable medium produce an article of manufacture including instructions which implement the function/act specified in the flowchart and/or block diagram block or blocks.

The machine executable instructions or computer program instructions may also be loaded onto a computer, other programmable data processing apparatus, or other devices to cause a series of operational steps to be performed on the computer, other programmable apparatus or other devices to produce a computer implemented process such that the instructions which execute on the computer or other programmable apparatus provide processes for implementing the functions/acts specified in the flowchart and/or block diagram block or blocks.

A 'user interface' as used herein is an interface which allows a user or operator to interact with a computer or computer system. A 'user interface' may also be referred to as a 'human interface device.' A user interface may provide information or data to the operator and/or receive information or data from the operator. A user interface may enable input from an operator to be received by the computer and may provide output to the user from the computer. In other words, the user interface may allow an operator to control or manipulate a computer and the interface may allow the computer to indicate the effects of the operator's control or manipulation. The display of data or information on a display or a graphical user interface is an example of providing information to an operator. The receiving of data through a keyboard, mouse, trackball, touchpad, pointing stick, graphics tablet, joystick, gamepad, webcam, headset, pedals, wired glove, remote control, and accelerometer are all examples of user interface components which enable the receiving of information or data from an operator.

A 'hardware interface' as used herein encompasses an interface which enables the computational system of a computer system to interact with and/or control an external computing device and/or apparatus. A hardware interface may allow a computational system to send control signals or instructions to an external computing device and/or apparatus. A hardware interface may also enable a computational system to exchange data with an external computing device and/or apparatus. Examples of a hardware interface include but are not limited to: a universal serial bus, IEEE 1394 port, parallel port, IEEE 1284 port, serial port, RS-232 port, IEEE-488 port, Bluetooth connection, Wireless local area network connection, TCP/IP connection, Ethernet connection, control voltage interface, MIDI interface, analog input interface, and digital input interface.

A 'display' or 'display device' as used herein encompasses an output device or a user interface adapted for displaying images or data. A display may output visual, audio, and or tactile data. Examples of a display include, but are not limited to: a computer monitor, a television screen, a touch screen, tactile electronic display, Braille screen, Cathode ray tube (CRT), Storage tube, Bi-stable display, Electronic paper, Vector display, Flat panel display, Vacuum fluorescent display (VF), Light-emitting diode (LED) displays, Electroluminescent display (ELD), Plasma display panels (PDP), Liquid crystal display (LCD), Organic light-emitting diode displays (OLED), a projector, and Head-mounted display.

While the invention has been illustrated and described in detail in the drawings and foregoing description, such illustration and description are to be considered illustrative or exemplary and not restrictive; the invention is not limited to the disclosed embodiments.

Other variations to the disclosed embodiments can be understood and effected by those skilled in the art in practicing the claimed invention, from a study of the drawings, the disclosure, and the appended claims. In the claims, the word "comprising" does not exclude other elements or steps, and the indefinite article "a" or "an" does not exclude a plurality. A single processor or other unit may fulfill the functions of several items recited in the claims. The mere fact that certain measures are recited in mutually different dependent claims does not indicate that a combination of these measures cannot be used to advantage. A computer program may be stored/distributed on a suitable medium, such as an optical storage medium or a solid-state medium supplied together with or as part of other hardware, but may also be distributed in other forms, such as via the Internet or other wired or wireless telecommunication systems. Any reference signs in the claims should not be construed as limiting the scope.

**Claims**

1. A medical system (100) comprising:

   a motion detection component (122) configured for determining position data (146, 152) descriptive of a subject within an imaging zone;
   a computational system (132) configured to:

   determine (200) initial position data (146) using the motion detection component;
   acquire (202) an initial coil sensitivity map (148) by controlling a magnetic resonance imaging system with coil sensitivity map pulse sequence commands;
   acquire (204) imaging k-space data (150) according to a parallel imaging magnetic resonance imaging protocol by controlling the magnetic resonance imaging system with imaging pulse sequence commands;
   determine (206) subsequent position data (152) using the motion detection component;
   acquire (208) at least one subsequent coil sensitivity map (154) by controlling the magnetic resonance imaging system with the coil sensitivity map pulse sequence commands if the subsequent position data varies by more than a predetermined change since acquisition of a most recent coil sensitivity map;
   reconstruct (212) a magnetic resonance image (160, 402) based on the imaging k-space data and the at least one subsequent coil sensitivity map.

**2.** The system of claim 1, wherein the computational system is configured to:
form (210) a collection of available coil sensitivity maps (158) from the initial coil sensitivity map and the at least one subsequent coil sensitivity map, wherein the collection of available coil sensitivity maps are preferably referenced to respective position data determined with the motion detection component; and
wherein reconstruction (212) of the magnetic resonance image (160, 402) from the imaging k-space data is based on a joint optimization using the collection of available coil sensitivity maps.

**3.** The medical system of claim 1 or 2, wherein the at least one subsequent coil sensitivity map comprises a final coil sensitivity map acquired after acquisition of the imaging k-space data is finished.

**4.** The medical system of any of the preceding claims, wherein the computational system is configured to repeatedly determine the subsequent position data during the acquisition of the k-space data.

**5.** The medical system of any one of the preceding claims, wherein the computational system is configured to reuse the collection of available coil sensitivity maps during the reconstruction of a subsequent magnetic resonance image from subsequently acquired k-space data.

**6.** The medical system of any one of the preceding claims, wherein the computational system is further configured to pause the acquisition of the imaging k-space data to acquire the at least one subsequent coil sensitivity map.

**7.** The medical system of any one of the preceding claims, wherein the computational system is configured to:

generate an additional coil sensitivity map by numerically combining the initial coil sensitivity map and the at least one subsequent coil sensitivity map; and
appending the additional coil sensitivity maps to the collection of available coil sensitivity maps.

**8.** The medical system of any one of the preceding claims, wherein the computational system is configured to perform the joint optimization such that a coil sensitivity parameter is varied for different parts of the imaging k-space data, wherein the coil sensitivity parameter specifies one of the collection of available coil sensitivity maps.

**9.** The medical system of any one of the preceding claims, wherein the computational system is configured to solve the joint optimization such that coil sensitivity maps are selected, at least initially, from the collection of coil sensitivity maps using the respective position data.

**10.** The medical system of any one of the preceding claims, wherein the at least one subsequent coil sensitivity map and the imaging k-space data are acquired using time stamps, wherein the computational system is configured to perform a selection of the at least one coil sensitivity map of the collection of available coil sensitivity maps for different portions of the imaging k-space data for the joint optimization, at least initially, using the time stamps.

**11.** The medical system of any one of the preceding claims, wherein the motion detection component is at least partially implemented using a camera system.

**12.** The medical system of any one of the preceding claims, wherein the motion detection component is at least partially implemented using magnetic resonance imaging navigators.

**13.** The medical system of any one of the preceding claims, wherein the computational system is configured to determine the position data from the imaging k-space data.

**14.** A method of operating a medical system (100), comprising:

determining (200) initial position data (146) using a motion detection component, wherein the initial position data (146, 152) is descriptive of a subject within an imaging zone;
acquiring (202) an initial coil sensitivity map (148) by controlling a magnetic resonance imaging system with coil sensitivity map pulse sequence commands;
acquiring (204) imaging k-space data (150) according to a parallel imaging magnetic resonance imaging protocol by controlling the magnetic resonance imaging system with imaging pulse sequence commands;
determining (206) subsequent position data (152) using the motion detection component;
acquiring (208) at least one subsequent coil sensitivity map (154) by controlling the magnetic resonance imaging system with the coil sensitive map pulse sequence commands if the subsequent position data varies by more than a predetermined change since acquisition of a most recent coil sensitivity map;
reconstructing (212) a magnetic resonance image (160, 402) based on the imaging k-space data and the at least one subsequent coil sensitivity map.

15. The method of claim 14, further comprising:
forming (210) a collection of available coil sensitivity maps (158) from the initial coil sensitivity map and the at least one subsequent coil sensitivity map; and
wherein reconstructing (212) the magnetic resonance image (160, 402) from the imaging k-space data is based on a joint optimization using the collection of available coil sensitivity maps.

Fig. 1

200

determine initial position data using the motion detection component

202

acquire an initial coil sensitivity map by controlling the magnetic resonance imaging system with the coil sensitivity map pulse sequence commands

204

acquire imaging k-space data according to a parallel imaging magnetic resonance imaging protocol by controlling the magnetic resonance imaging system with the imaging pulse sequence commands

206

determine subsequent position data using the motion detection component

208

acquire at least one subsequent coil sensitivity map by controlling the magnetic resonance imaging system with the coil sensitive map pulse sequence commands if the subsequent position data varies by more than a predetermined change since acquisition of a most recent coil sensitivity map

210

form a collection of available coil sensitivity maps from the initial coil sensitivity map and the at least one subsequent coil sensitivity map

212

reconstruct a magnetic resonance image from the imaging k-space data using a joint optimization using the collection of available coil sensitivity maps

## Fig. 2

Fig. 3

Fig. 4

Europäisches
Patentamt

European
Patent Office

Office européen
des brevets

## EUROPEAN SEARCH REPORT

**Application Number**

EP 24 17 5369

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | EP 3 524 996 A1 (KONINKLIJKE PHILIPS NV [NL]) 14 August 2019 (2019-08-14) | 1-6,8-15 | INV.<br>G01R33/561 |
| A | * paragraphs [0006] - [0037], [0045], [0090] - [0123]; claims 1-9, 13,14; figure 6 * | 7 | G01R33/565 |
| | ----- | | |
| X | US 2020/249302 A1 (VAN DEN BRINK JOHAN SAMUEL [NL]) 6 August 2020 (2020-08-06) | 1,3-6, 11-14 | |
| A | * paragraphs [0005] - [0014], [0022], [0023], [0031] - [0033], [0038] - [0042]; claims 1,16 * | 2,7-10 | |
| | ----- | | |
| A | US 2019/250236 A1 (PAUL DOMINIK [DE] ET AL) 15 August 2019 (2019-08-15)<br>* paragraphs [0007] - [0035], [0062], [0075] - [0081]; claims 1-12 * | 1-15 | |
| | ----- | | |

**TECHNICAL FIELDS
SEARCHED (IPC)**

G01R

The present search report has been drawn up for all claims

| Place of search | Date of completion of the search | Examiner |
|---|---|---|
| Munich | 15 October 2024 | Faber-Jurk, Sonja |

EPO FORM 1503 03.82 (P04C01)

**EP 4 650 810 A1**

## ANNEX TO THE EUROPEAN SEARCH REPORT
## ON EUROPEAN PATENT APPLICATION NO.

EP 24 17 5369

15-10-2024

| Patent document cited in search report | | | Publication date | Patent family member(s) | | Publication date |
|---|---|---|---|---|---|---|
| EP 3524996 | A1 | 14-08-2019 | | NONE | | |
| US 2020249302 | A1 | 06-08-2020 | | CN | 111095011 A | 01-05-2020 |
| | | | | EP | 3457160 A1 | 20-03-2019 |
| | | | | EP | 3682256 A1 | 22-07-2020 |
| | | | | JP | 7216718 B2 | 01-02-2023 |
| | | | | JP | 2020533114 A | 19-11-2020 |
| | | | | US | 2020249302 A1 | 06-08-2020 |
| | | | | WO | 2019053047 A1 | 21-03-2019 |
| US 2019250236 | A1 | 15-08-2019 | | DE | 102018202137 A1 | 14-08-2019 |
| | | | | US | 2019250236 A1 | 15-08-2019 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **CORDERO-GRANDE**. Sensitivity Encoding for Aligned Multishot Magnetic Resonance Reconstruction. *IEEE Trans. on Computational Imaging*, September 2016, vol. 2 (3), 266-280